# FASCICULE DE BREVET EUROPEEN

(11) **EP 2 075 222 B1**
(45) Date de publication et mention de la délivrance du brevet: **07.07.2010**
(21) Numéro de dépôt: 08172514.5
(22) Date de dépôt: 22.12.2008
(51) Int. Cl.: B81C 1/00

(54) **Procédé de fabrication de composants mécaniques de structures MEMS ou NEMS en silicium monocristallin**
Method of manufacturing mechanical components of MEMS or NEMS structures in monocrystalline silicon
Herstellungsverfahren von mechanischen Komponenten von MEMS- oder NEMS-Strukturen aus monokristallinem Silizium

(30) Priorité: 28.12.2007 FR 0760426
(43) Date de publication de la demande: 01.07.2009
(73) Titulaire: Commissariat à l'Énergie Atomique et aux Énergies Alternatives, 75015 Paris (FR)
(72) Inventeur: Robert, Philippe, 38000, GRENOBLE (FR); Nguyen, Valérie, 38760, VARCES (FR)
(74) Mandataire: Ilgart, Jean-Christophe

(56) Documents cités:
- DE-A1- 10 235 371
- FR-A- 2 857 952
- US-A- 5 198 390

## Description

### DOMAINE TECHNIQUE

L'invention se rapporte à un procédé de fabrication de composants mécaniques de structures MEMS (pour "Micro-Electro-Mechanical System") ou NEMS (pour "Nano-Electro-Mechanical System") en silicium monocristallin. Ces structures sont notamment utilisées pour la réalisation de capteurs et d'actionneurs.

### ETAT DE LA TECHNIQUE

L'utilisation du silicium monocristallin pour la réalisation de composants MEMS ou NEMS est intéressante à plusieurs titres. Ses propriétés mécaniques sont excellentes, notamment par rapport au silicium polycristallin. De fortes épaisseurs peuvent être utilisées (dans le cas du silicium polycristallin, l'épaisseur est généralement limitée à 20 µm). Il possède de très bonnes propriétés piézoélectriques. Ses propriétés semiconductrices, bien connues et bien maîtrisées, permettent une co-intégration de ces composants mécaniques avec l'électronique associée.

Dans l'état de l'art, on trouve trois grands modes de réalisation de structures MEMS/NEMS en silicium monocristallin, c'est-à-dire des composants mécaniques libérés, à même de pouvoir se déplacer sous l'action d'une force extérieure, en technologie de surface.

La technologie SOI est la plus répandue (voir l'article "Industrial MEMS ou SOI" de Stéphane RENARD, J. Micromech. Microeng. 10 (2000), 245-249). Dans ce cas, le composant est réalisé sur la couche active du substrat SOI et l'oxyde enterré sert à la fois de couche d'arrêt de gravure du silicium et de couche sacrificielle. La libération de la structure mécanique se fait par la face avant du substrat. Une première variante consiste à graver toute la face arrière pour libérer le composant mécanique, en s'arrêtant sur l'oxyde enterré. La libération se fait alors par la face arrière du substrat. Une deuxième variante consiste à reporter le substrat SOI sur une cavité pour le libérer par simple gravure du silicium.

L'intérêt de la technologie SOI pour les MEMS repose sur l'oxyde enterré que permet à la fois :
- de servir de couche d'arrêt à la gravure du silicium, et donc de définir avec précision l'épaisseur de la couche de silicium sur laquelle sera faite le composant (quelle que soit la variante),
- de servir de couche sacrificielle (dans le cas d'un procédé face avant principalement),
- d'avoir une couche isolante électrique soutenant le composant MEMS/NEMS (pour éviter de mettre tous les éléments du MEMS ou du NEMS en court-circuit).

Par contre, le gros inconvénient de la technologie SOI est son prix élevé. On a également observé récemment des problèmes de contraintes mal contrôlées dans le SOI qui, dans certaines configurations, sont très dommageables pour les MEMS/NEMS.

Dans la technologie SON (pour "Silicon-on-Nothing"), on fait croître une couche de SiGe sur un substrat de silicium standard, et sur cette couche de Signe, on fait croître une couche de silicium monocristallin. Le composant MEMS/NEMS est réalisé sur cette dernière couche de silicium et le SiGe sert de couche sacrificielle. Pour la libération, on utilise une gravure sèche du SiGe à base de CF₄, sélective par rapport au silicium monocristallin.

On peut se référer à ce sujet à l'article "Silicon on nothing MEMS electromechanical resonator" de C. DURAND et al., Microsyst. Technol. (2008) 14: 1027-1033. L'intérêt principal de la technologie SON, c'est qu'il s'agit d'un procédé bas coût. Cela permet également d'avoir accès à des épaisseurs de silicium très faibles (typiquement quelques 100 nm), par exemple pour les NEMS. Ses inconvénients sont par contre multiples.

La gravure isotrope du SiGe est assez faiblement sélective par rapport au silicium. On est donc limité à des libérations de motifs étroits (typiquement inférieurs au µm). L'épaisseur de silicium épitaxié sur le SiGe est généralement limitée à quelques centaines de nanomètres (des dislocations risquent d'apparaître si l'on souhaite obtenir de fortes épaisseurs de silicium). Le SiGe est semiconducteur. Pour avoir des zones isolées électriquement sur le MEMS/NEMS, cela suppose de mettre une couche isolante dans les zones devant être isolées électriquement (dépôt SiO₂ ou SiN par exemple). La couche de silicium épitaxiée au-dessus de cette couche isolante sera polycristalline (et non monocristalline). Ce point peut être assez critique puisque ces zones correspondent à des zones d'ancrage où le matériau est particulièrement sollicité. Le fait d'avoir un matériau polycristallin dans ces zones d'ancrage (plutôt que monocristallin) conduit soit à avoir un moins bon facteur de qualité, dans le cas de structures résonnantes, soit à être plus sensible à des contraintes mécaniques (par exemple la tenue aux chocs).

Dans la technologie SCREAM (voir le brevet US 5 198 390), on part d'un substrat standard pour réaliser un composant MEMS et on utilise une partie "enterrée" du silicium massif comme couche sacrificielle. Le procédé se décompose de la manière suivante : gravure DRIE (pour "Deep Reactive Ion Etching" ou gravure ionique réactive profonde) de la structure MEMS, oxydation thermique, gravure anisotrope de l'oxyde, gravure isotrope du silicium pour libérer le MEMS, métallisation de la structure (sur les flancs et le dessus).

L'intérêt principal de la technologie SCREAM, c'est sa simplicité et son aspect bas coût.

Ses inconvénients sont par contre multiples. Il n'y a pas d'ancrage isolant. Cela se solde par la création de contraintes mécaniques importantes sur le MEMS (dus à la présence de l'oxyde thermique et du métal sur les structures libérées). Cet ajout d'oxyde et de métal sur le silicium monocristallin rend le composant mécanique moins bon (moins bon facteur de qualité dans le cas d'un résonateur par exemple). La métallisation, qui se fait après libération de la structure, nécessite l'utilisation d'un masquage mécanique lors du dépôt. Cette méthode est peu industrielle et donne une résolution des motifs très médiocre.

La technologie SCREAM procure des structures mal définies et qui se gravent sous le masque d'oxyde lors de la gravure isotrope du silicium (absence d'oxyde sous la structure à libérer).

### EXPOSE DE L'INVENTION

La présente invention a été conçue pour remédier aux inconvénients des procédés de l'art antérieur décrits ci-dessus.

Le procédé selon l'invention peut être utilisé pour toutes les applications MEMS et NEMS. Il met en oeuvre une technologie adaptée aux marchés bas coût et grands volumes : téléphonie mobile, automobile, jeux, .... A titre d'exemple, on peut citer :
- pour les automobiles : les accéléromètres, les gyromètres, les capteurs de pression, les capteurs chimiques à base de résonateurs mécaniques MEMS ou NEMS,
- pour la téléphonie mobile : les bases de temps (résonateurs RF), les filtres mécaniques MEMS ou NEMS, les accéléromètres, les microphones,
- pour les jeux : les accéléromètres, les gyromètres.

L'invention a pour objet un procédé de fabrication d'au moins un composant mécanique de structure MEMS ou NEMS à partir d'un substrat de silicium monocristallin, comprenant les étapes de :
a) formation de zones d'ancrage dans une face du substrat pour délimiter au moins en partie le composant mécanique,
b) formation, sur ladite face du substrat, d'une couche de protection inférieure en matériau autre que le silicium et obtenue par épitaxie à partir de ladite face du substrat, cette couche de protection inférieure étant monocristalline au moins en dehors des zones d'ancrage,
c) formation sur la couche de protection inférieure d'une couche de silicium obtenue par épitaxie à partir de la couche de protection inférieure, cette couche de silicium étant monocristalline au moins en dehors des zones d'ancrage,
d) formation d'une couche de protection supérieure sur la couche de silicium,
e) gravure de la couche de protection supérieure, de la couche de silicium et de la couche de protection inférieure, entre les zones d'ancrage, selon un motif de définition du composant mécanique, jusqu'à atteindre le substrat de silicium monocristallin et fournir des voies d'accès au substrat de silicium monocristallin,
f) formation d'une couche de protection sur les parois formées par la gravure du motif du composant mécanique dans la couche de silicium épitaxiée,
g) libération du composant mécanique par gravure isotrope du substrat de silicium monocristallin à partir des voies d'accès au substrat de silicium monocristallin, cette gravure isotrope n'attaquant pas les couches de protection inférieure et supérieure et la couche de protection des parois.

Avantageusement, les zones d'ancrage peuvent permettre d'isoler électriquement le composant mécanique du reste du substrat. Ces zones d'ancrage sont alors en matériau diélectrique.

Lors de l'étape e), la couche de protection supérieure, la couche de silicium et la couche de protection inférieure peuvent être également gravées dans les zones d'ancrage selon un motif apte à créer une zone d'isolation électrique dans les couches épitaxiées.

Selon un mode de réalisation particulier, avant l'étape e), il est prévu une étape de réalisation de plots de contact électrique pour le composant mécanique. Cette réalisation peut comprendre le dépôt d'une couche de matériau électriquement conducteur (par exemple en Al ou en AlSi) et sa gravure. Les plots de contact électrique peuvent être disposés sur les zones d'ancrage.

Selon un mode de mise en oeuvre particulier, le composant mécanique est fabriqué en intercalant entre les étapes c) et d) au moins les deux étapes suivantes :
- formation, sur la structure obtenue à l'étape c), d'une couche intermédiaire en matériau autre que le silicium et obtenue par épitaxie à partir de la couche de silicium déposée juste précédemment, cette couche intermédiaire étant monocristalline au moins en dehors des zones d'ancrage,
- formation sur la couche intermédiaire déposée juste précédemment d'une couche de silicium obtenue par épitaxie à partir de cette couche intermédiaire, cette couche de silicium étant monocristalline au moins en dehors des zones d'ancrage.

Les zones d'ancrage peuvent être formées en réalisant des tranchées dans ladite face du substrat et en remplissant ces tranchées par un matériau d'ancrage. Le matériau d'ancrage peut être un matériau permettant successivement la formation d'une couche épitaxiée simultanément à la couche de protection inférieure et la formation d'une autre couche épitaxiée simultanément à la couche de silicium.

La couche de protection des parois peut être formée par dépôt ou épitaxie d'une couche de protection épousant le relief de la structure gravée à l'étape e), puis par gravure anisotrope de cette couche de protection.

A titre d'exemple, les zones d'ancrage formées dans la face du substrat sont en nitrure de silicium ou en oxyde de silicium, la couche de protection en matériau autre que le silicium est du SiGe, la couche de protection supérieure est en nitrure de silicium ou en oxyde de silicium et la couche de protection sur les parois est en un matériau choisi parmi SiGe, l'oxyde de silicium et le nitrure de silicium.

### BREVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1I illustrent une mise en oeuvre du procédé de fabrication selon la présente invention,
- les figures 2A à 2C illustrent des étapes supplémentaires du procédé de fabrication selon la présente invention,
- les figures 3A et 3B illustrent une mise en oeuvre du procédé de fabrication selon la présente invention, permettant la fabrication d'un empilement de composants mécaniques.

### DESCRIPTION DETAILLEE DE MODES DE MISE EN OEUVRE DE LA PRESENTE INVENTION

Selon la présente invention, il est proposé d'utiliser un empilement de couches permettant la réalisation de structures MEMS ou NEMS en silicium monocristallin, réalisées sur la base de technologies planaires, compatibles CMOS, qui n'utilisent pas de substrat SOI. L'objectif étant d'avoir un procédé bas coût, compatible CMOS et permettant d'adresser un large éventail de motifs de MEMS et NEMS en silicium monocristallin (c'est-à-dire faiblement dépendant des règles de dessin).

Pour cela, le silicium massif est utilisé pour fournir la couche sacrificielle de la structure MEMS/NEMS. Il est prévu des ancrages, éventuellement en matériau électriquement isolant, formant zones d'arrêt à la gravure servant à la libération des composants mécaniques. Le composant MEMS ou NEMS est réalisé à partir d'une couche de silicium monocristallin épitaxiée. Le composant MEMS ou NEMS usiné est entièrement protégé avant l'étape de libération par des couches résistant à la chimie de gravure de libération. Ces couches comprennent une couche de protection inférieure (protégeant le composant mécanique par le dessous), une couche de protection supérieure (protégeant le composant mécanique par le dessus) et une couche de protection des parois formées par la gravure du motif du composant mécanique.

La couche de protection inférieure est en matériau monocristallin, autre que le silicium, et est épitaxiée à partir du substrat en silicium monocristallin. Elle présente les caractéristiques suivantes. Elle permet une recroissance de silicium monocristallin par épitaxie, avec éventuellement une possibilité de dopage in situ du silicium ainsi épitaxié. Elle résiste à une gravure sèche ou humide du silicium (gravure sélective) sans être attaquée ou en étant faiblement attaquée. Eventuellement, elle peut être gravée sélectivement par rapport au silicium par un procédé de gravure sèche ou humide.

La couche de protection supérieure et la couche de protection des parois du composant à libérer présentent les caractéristiques suivantes.

Elles peuvent résister à une gravure sèche ou humide du silicium (gravure sélective) sans être attaquées, ou en étant faiblement attaquées. Eventuellement, elles peuvent être gravées sélectivement par rapport au silicium par un procédé de gravure sèche ou humide. Préférentiellement, la couche de protection du dessus (ou couche d'arrêt dans la description de l'empilement) est sélective à la gravure de la couche de protection des parois (c'est-à-dire qu'elle ne se grave pas ou se grave peu, lors de l'étape de gravure de la couche de protection des parois).

La couche de protection du dessous peut par exemple être du SiGe monocristallin. La couche de protection des parois peut par exemple être du SiGe (monocristallin ou polycristallin), du SiO₂, du SiN,.... Cette couche devra être conforme (pour bien recouvrir les parois). La couche de protection sur le dessus (couche d'arrêt) peut par exemple être du SiO₂, du SiN,....

Des ancrages isolants électriquement (et/ou arrêt de gravure) pourront être réalisés, avant le dépôt de la couche de protection inférieure, en gravant le silicium massif, puis en comblant les cavités ainsi réalisées par dépôt d'un matériau isolant (par exemple SiO₂ ou SiN) et en retirant l'excédent par planarisation CMP ou par l'enchaînement litho-gravure et CMP. Dans le cas où ces ancrages ne servent que d'arrêt de gravure, le matériau de remplissage des cavités pourra être isolant, conducteur ou semiconducteur.

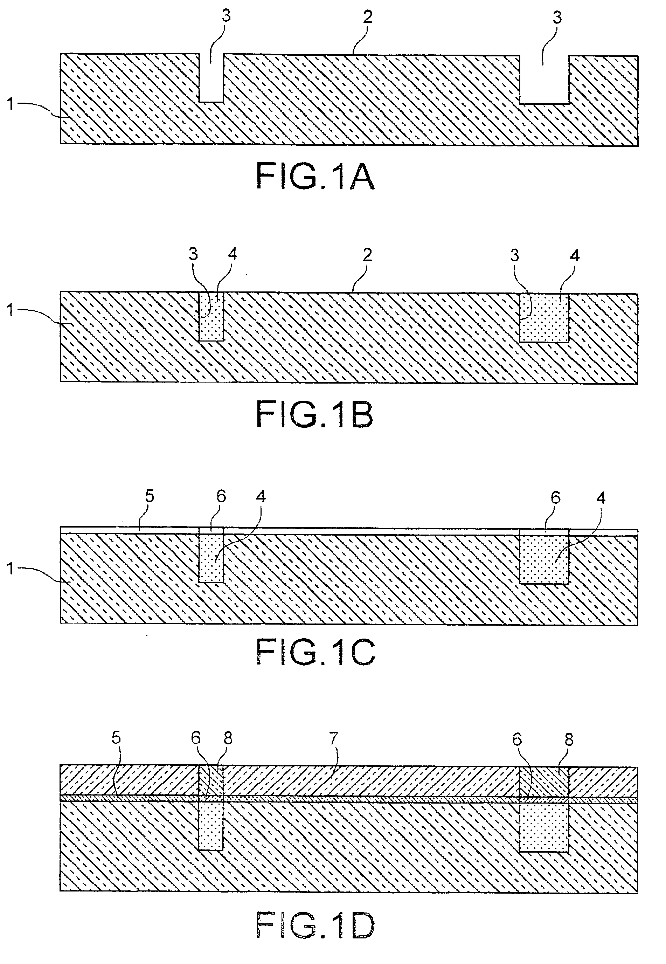

Les figures 1A à 1I illustrent les étapes principales d'une mise en oeuvre du procédé de fabrication selon la présente invention. Ces figures sont des vues en coupe transversale.

Sur la figure 1A, la référence 1 désigne un substrat massif en silicium monocristallin. A partir de la face supérieure 2 du substrat 1, on réalise des tranchées 3 destinées à recevoir les zones d'ancrage servant à isoler électriquement et/ou à délimiter le composant mécanique à réaliser.

Les tranchées 3 sont ensuite bouchées par dépôt d'un matériau d'ancrage (par exemple SiN, SiO₂, ...) suivi d'un polissage mécano-chimique (ou CMP) avec arrêt sur la face 2 du substrat 1. Le résultat obtenu est montré sur la figure 1B. La référence 4 désigne les ancrages obtenus.

On procède ensuite, sur la face 2 du substrat 1 à l'épitaxie d'une couche monocristalline, par exemple une couche 5 de SiGe d'épaisseur 50 nm pour obtenir la couche de protection inférieure (voir la figure 1C). Le substrat 1 étant monocristallin, la couche épitaxiée 5 est également monocristalline. Par contre, sur les ancrages 4, les zones épitaxiées 6 sont en SiGe polycristallin.

On procède ensuite à l'épitaxie d'une couche de silicium, de quelques dizaines de nm à quelques µm d'épaisseur, sur la couche 5 et les zones 6. On obtient, sur la couche 5, une couche de silicium monocristallin 7 et, sur les zones 6, des zones 8 de silicium polycristallin (voir la figure 1D).

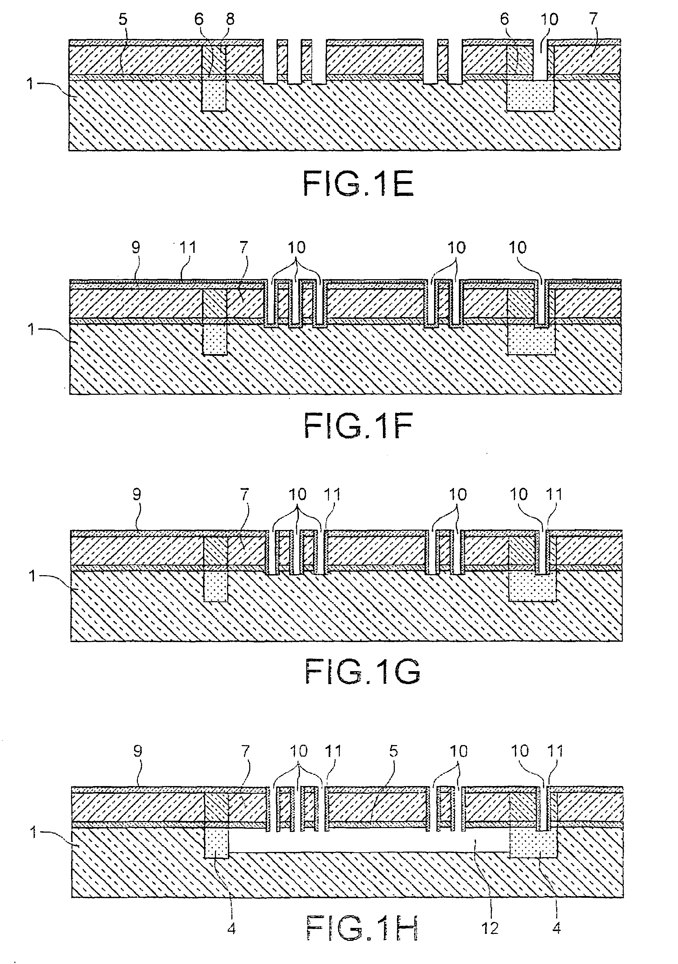

On dépose ensuite, comme le montre la figure 1E, la couche de protection supérieure ou couche d'arrêt 9 sur la structure obtenue précédemment. Cette couche d'arrêt 9 est sélective par rapport à la gravure de libération du composant mécanique, c'est-à-dire par rapport au silicium monocristallin du substrat, et préférentiellement par rapport à la couche de protection inférieure 5. C'est par exemple une couche de SiO₂. On effectue ensuite une litho-gravure DRIE de la couche de protection supérieure 9, de la couche de silicium 7 et de la couche de protection inférieure 5, entre les zones d'ancrage, selon un motif de définition du composant mécanique, jusqu'à atteindre et révéler le substrat en silicium 1 et pour fournir des voies d'accès 10 à ce substrat.

Ensuite, on forme par dépôt ou par épitaxie une couche de protection des parois formées par la gravure du motif du composant mécanique. Lorsqu'elle est formée, cette couche de protection 11 recouvre la couche de protection supérieure 9, les parois des voies d'accès 10 et le fond des voies d'accès, c'est-à-dire le substrat de silicium 1 précédemment révélé. C'est ce que montre la figure 1F.

La couche de protection 11 est ensuite gravée de manière anisotrope avec arrêt sur la couche de protection supérieure 9. Cette gravure permet de ne conserver la couche de protection 11 que sur les parois des voies d'accès 10, le silicium du substrat 1 étant à nouveau révélé (voir la figure 1G).

On peut alors procéder à la gravure isotrope du silicium du substrat 1, entre les ancrages 4. Cette gravure est sélective par rapport aux couches de protection 5, 9 et 11. Le silicium du composant mécanique, c'est-à-dire le matériau de la couche 7, demeure intact. On obtient une cavité 12 sous le composant mécanique ainsi libéré (voir la figure 1H). L'épaisseur gravée du substrat 1 peut être comprise entre quelques centaines de nm et quelques µm.

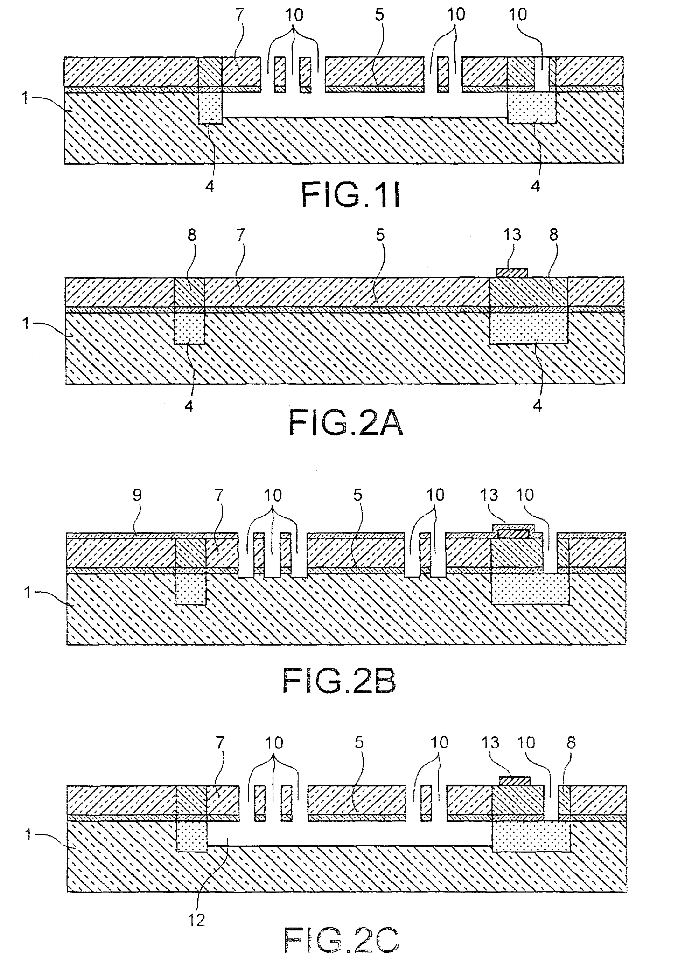

On peut alors procéder à l'élimination, par gravure sélective par rapport au silicium monocristallin, de la couche de protection supérieure ou couche d'arrêt 9 et de la couche de protection des parois 11. Le résultat obtenu est montré sur la figure 1I. Eventuellement, la couche de protection inférieure 5 peut aussi être éliminée par gravure sélective.

Les ancrages dans le silicium peuvent servir à isoler électriquement la structure MEMS/NEMS une fois libérée, mais ils peuvent servir également d'arrêt de gravure à l'étape de libération. Dans le cas où l'isolation électrique n'est pas nécessaire, ces ancrages peuvent éventuellement être conducteurs ou semiconducteurs et jouer simplement ce rôle d'arrêt de gravure. Bien évidemment, cela suppose que le matériau de ces ancrages ne se grave pas lors de cette étape de libération. L'homme de l'art saura quel matériau utiliser.

Des étapes supplémentaires peuvent venir s'intercaler dans ce procédé, comme par exemple une métallisation de la structure pour la reprise de contact avant la gravure du MEMS, ou un dépôt et une planarisation du MEMS une fois libéré pour continuer d'autres étapes en fin de procédé. Les matériaux et étapes additionnels devront bien évidemment être compatibles avec le procédé complet décrit précédemment. Néanmoins, l'homme de l'art sera en mesure de les déterminer.

A titre d'exemple, les figures 2A à 2C illustrent un ajout d'étapes pour la réalisation de plots de contact. Sur ces figures, les mêmes éléments que sur les figures 1A à 1I sont référencés à l'identique.

Après l'étape d'épitaxie de silicium, fournissant la couche de silicium monocristallin 7 et les zones 8 de silicium polycristallin, on forme des plots de contact électrique sur les zones 8. Ces plots de contact sont formés par dépôt d'une couche métallique et litho-gravure. La figure 2A montre l'un de ces plots 13.

On procède ensuite au dépôt de la couche de protection supérieure ou couche d'arrêt 9 et à la litho-gravure DRIE de la couche de protection supérieure 9, de la couche de silicium 7 et de la couche de protection inférieure 5, jusqu'à atteindre et révéler le substrat en silicium 1 et pour fournir les voies d'accès 10 au substrat. C'est ce que montre la figure 2B.

La figure 2C représente la structure obtenue à la fin du procédé selon l'invention.

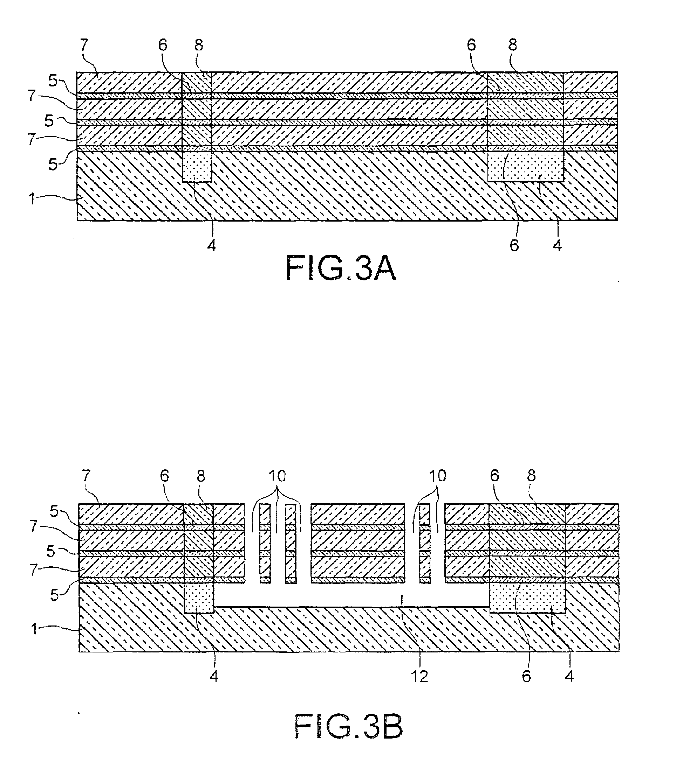

Les figures 3A et 3B illustrent une mise en oeuvre du procédé de fabrication selon la présente invention, permettant la fabrication d'un empilement de composants mécaniques.

Cet empilement est obtenu en alternant couche de protection 5 en matériau monocristallin autre que le silicium (et permettant une épitaxie de silicium monocristallin), par exemple SiGe et couche de silicium monocristallin épitaxiée 7 sur le substrat 1 pourvu de ses ancrages 4 (voir la figure 3A). Les différentes épitaxies font également alterner les zones épitaxiées 6 en SiGe polycristallin et 8 en silicium polycristallin.

Les étapes suivantes sont identiques aux étapes correspondantes déjà décrites. Après l'étape de libération et l'élimination de la couche d'arrêt supérieure et de la couche de protection des parois, on obtient la structure représentée à la figure 3B.

L'invention procure un certain nombre d'avantages. Elle permet un empilement technologique bas coût reposant sur des étapes technologiques classiques de la microélectronique et utilisant un substrat standard. Le procédé de l'invention peut être compatible CMOS. Il procure un encastrement pouvant être électriquement isolant et ainsi ne pas nécessiter d'isoler le MEMS ou le NEMS par des dépôts diélectrique et métallique supplémentaires tels que mis en oeuvre dans la technique SCREAM. Dans le cas où la couche de protection du silicium est du SiGe, la gravure du silicium peut être très sélective par rapport à cette dernière. On peut donc libérer de grands motifs, ce qui donne de la souplesse quant aux motifs que l'on peut réaliser par cette technologie. Les ancrages, électriquement isolants ou non, réalisés dans le silicium peuvent servir d'arrêt de gravure lors de l'étape de libération. Il en résulte un meilleur contrôle de l'étape de libération (pas de risque de surgravure par exemple) et un accès à des motifs variés : la forme des structures libérées n'est plus limitée par la nature isotrope de la gravure de libération, d'où par exemple la possibilité de réaliser des membranes suspendues carrées et hexagonales, et non plus seulement circulaires.

## Revendications

1. Procédé de fabrication d'au moins un composant mécanique de structure MEMS ou NEMS à partir d'un substrat de silicium monocristallin (1), comprenant les étapes de :
a) formation de zones d'ancrage (4) dans une face (2) du substrat (1) pour délimiter au moins en partie le composant mécanique,
b) formation, sur ladite face (2) du substrat (1), d'une couche de protection inférieure (5) en matériau autre que le silicium et obtenue par épitaxie à partir de ladite face du substrat, cette couche de protection inférieure étant monocristalline au moins en dehors des zones d'ancrage,
c) formation sur la couche de protection inférieure (5) d'une couche de silicium (7) obtenue par épitaxie à partir de la couche de protection inférieure, cette couche de silicium (7) étant monocristalline au moins en dehors des zones d'ancrage,
d) formation d'une couche de protection supérieure (9) sur la couche de silicium (7),
e) gravure de la couche de protection supérieure (9), de la couche de silicium (7) et de la couche de protection inférieure (5), entre les zones d'ancrage (4), selon un motif de définition du composant mécanique, jusqu'à atteindre le substrat de silicium monocristallin (1) et fournir des voies d'accès (10) au substrat de silicium monocristallin,
f) formation d'une couche de protection (11) sur les parois formées par la gravure du motif du composant mécanique dans la couche de silicium épitaxiée (7),
g) libération du composant mécanique par gravure isotrope du substrat de silicium monocristallin (1) à partir des voies d'accès (10) au substrat de silicium monocristallin, cette gravure isotrope n'attaquant pas les couches de protection inférieure (5) et supérieure (9) et la couche de protection des parois (11).

2. Procédé selon la revendication 1, dans lequel, lors de l'étape e), la couche de protection supérieure, la couche de silicium et la couche de protection inférieure sont également gravées dans les zones d'ancrage selon un motif apte à créer une zone d'isolation électrique dans les couches épitaxiées.

3. Procédé selon la revendication 1, dans lequel, avant l'étape e), il est prévu une étape de réalisation de plots de contact électrique (13) pour le composant mécanique.

4. Procédé selon la revendication 3, dans lequel la réalisation des plots de contact électrique (13) comprend le dépôt d'une couche de matériau électriquement conducteur et sa gravure.

5. Procédé selon l'une des revendications 3 ou 4, dans lequel les plots de contact électrique (13) sont disposés sur les zones d'ancrage.

6. Procédé selon l'une quelconque des revendications 1 à 5, dans lequel le composant mécanique est fabriqué en intercalant entre les étapes c) et d) au moins les deux étapes suivantes :
- formation, sur la structure obtenue à l'étape c), d'une couche intermédiaire en matériau autre que le silicium et obtenue par épitaxie à partir de la couche de silicium déposée juste précédemment, cette couche intermédiaire étant monocristalline au moins en dehors des zones d'ancrage,
- formation sur la couche intermédiaire déposée juste précédemment d'une couche de silicium obtenue par épitaxie à partir de cette couche intermédiaire, cette couche de silicium étant monocristalline au moins en dehors des zones d'ancrage.

7. Procédé selon l'une quelconque des revendications 1 à 6, dans lequel les zones d'ancrage sont formées en réalisant des tranchées (3) dans ladite face (2) du substrat (1) et en remplissant ces tranchées par un matériau d'ancrage (4).

8. Procédé selon la revendication 7, dans lequel le matériau d'ancrage est un matériau permettant successivement la formation d'une couche épitaxiée (6) simultanément à la couche de protection inférieure (5) et la formation d'une autre couche épitaxiée (8) simultanément à la couche de silicium (7).

9. Procédé selon l'une quelconque des revendications 1 à 8, dans lequel la couche de protection des parois est formée par dépôt ou épitaxie d'une couche de protection (11) épousant le relief de la structure gravée à l'étape e), puis par gravure anisotrope de cette couche de protection (11).

10. Procédé selon l'une quelconque des revendications 1 à 9, dans lequel les zones d'ancrage sont formées d'un matériau électriquement isolant.

11. Procédé selon l'une quelconque des revendications 1 à 10, dans lequel les zones d'ancrage formées dans la face (2) du substrat (1) sont en nitrure de silicium ou en oxyde de silicium.

12. Procédé selon l'une quelconque des revendications 1 à 11, dans lequel la couche de protection inférieure en matériau autre que le silicium est du SiGe.

13. Procédé selon l'une quelconque des revendications 1 à 12, dans lequel la couche de protection supérieure (9) est en nitrure de silicium ou en oxyde de silicium.

14. Procédé selon l'une quelconque des revendications 1 à 13, dans lequel la couche de protection sur les parois (11) est en un matériau choisi parmi SiGe, l'oxyde de silicium et le nitrure de silicium.

15. Procédé selon l'une quelconque des revendications 1 à 14, dans lequel, après l'étape de libération du composant mécanique, il est prévu une étape d'élimination de la couche de protection supérieure (9) et de la couche de protection des parois (11).

16. Procédé selon l'une quelconque des revendications 1 à 15, dans lequel, après l'étape de libération du composant mécanique, il est prévu une étape d'élimination de la couche de protection inférieure (5).

## Claims

1. Method of producing at least one mechanical component of MEMS or NEMS structure from a monocrystalline silicon substrate (1), comprising the steps of:
a) forming anchoring zones (4) in one face (2) of the substrate (1) to delimit at least in part the mechanical component,
b) forming, on said face (2) of the substrate (1), a lower protective layer (5) made of material other than silicon and obtained by epitaxy from said face of the substrate, wherein this lower protective layer is monocrystalline at least outside of the anchoring zones,
c) forming on the lower protective layer (5) a silicon layer (7) obtained by epitaxy from the lower protective layer, wherein this silicon layer (7) is monocrystalline at least outside of the anchoring zones,
d) forming an upper protective layer (9) on the silicon layer (7),
e) etching the upper protective layer (9), the silicon layer (7) and the lower protective layer (5), between the anchoring zones (4), according to a pattern defining the mechanical component, until the monocrystalline silicon substrate (1) is reached and to provide access routes (10) to the monocrystalline silicon substrate,
f) forming a protective layer (11) on the walls formed by the etching of the pattern of the mechanical component in the epitaxied silicon layer (7),
g) releasing the mechanical component by isotropic etching of the monocrystalline silicon substrate (1) from the access routes (10) to the monocrystalline silicon substrate, this isotropic etching not attacking the lower (5) and upper (9) protective layers and the protective layer of the walls (11).

2. Method according to claim 1, in which, during step e), the upper protective layer, the silicon layer and the lower protective layer are also etched in the anchoring zones according to a pattern suited to creating an electrically insulating zone in the epitaxied layers.

3. Method according to claim 1, in which, before step e), a step of producing electrical contact pads (13) for the mechanical component is provided for.

4. Method according to claim 3, in which the production of the electrical contact pads (13) comprises the deposition of a layer of electrically conducting material and its etching.

5. Method according to one of claims 3 or 4, in which the electrical contact pads (13) are arranged on the anchoring zones.

6. Method according to any of claims 1 to 5, in which the mechanical component is manufactured by inserting between steps c) and d) at least the following two steps:
- forming, on the structure obtained in step c), an intermediate layer made of material other than silicon and obtained by epitaxy from the silicon layer deposited just previously, wherein this intermediate layer is monocrystalline at least outside of the anchoring zones,
- forming on the intermediate layer deposited just previously a silicon layer obtained by epitaxy from this intermediate layer, wherein this silicon layer is monocrystalline at least outside of the anchoring zones.

7. Method according to any of claims 1 to 6, in which the anchoring zones are formed by producing trenches (3) in said face (2) of the substrate (1) and by filling these trenches with an anchoring material (4).

8. Method according to claim 7, in which the anchoring material is a material enabling successively the formation of a layer epitaxied (6) simultaneously with the lower protective layer (5) and the formation of another layer epitaxied (8) simultaneously with the silicon layer (7).

9. Method according to any of claims 1 to 8, in which the protective layer of the walls is formed by deposition or epitaxy of a protective layer (11) closely hugging the relief of the structure etched in step e), then by anisotropic etching of this protective layer (11).

10. Method according to any of claims 1 to 9, in which the anchoring zones are formed from an electrically insulating material.

11. Method according to any of claims 1 to 10, in which the anchoring zones formed in the face (2) of the substrate (1) are made of silicon nitride or silicon oxide.

12. Method according to any of claims 1 to 11, in which the lower protective layer made of material other than silicon is SiGe.

13. Method according to any of claims 1 to 12, in which the upper protective layer (9) is made of silicon nitride or silicon oxide.

14. Method according to any of claims 1 to 13, in which the protective layer on the walls (11) is made of a material chosen among SiGe, silicon oxide and silicon nitride.

15. Method according to any of claims 1 to 14, in which, after the release step of the mechanical component, a step of elimination of the upper protective layer (9) and the protective layer of the walls (11) is provided for.

16. Method according to any of claims 1 to 15, in which, after the step of release of the mechanical component, a step of elimination of the lower protective layer (5) is provided for.

## Patentansprüche

1. Verfahren zur Herstellung von wenigstens einer mechanischen Komponente der MEMS- oder NEMS-Struktur, ausgehend von einem monokristallinen Siliciumsubstrat (1), die folgenden Schritte umfassend:
a) Ausbilden von Verankerungszonen (4) auf einer Seite (2) des Substrats (1), um die mechanische Komponente wenigstens teilweise zu begrenzen,
b) Bilden - auf der genannten Seite (2) des Substrats (1) und durch Epitaxie auf dieser Seite - einer unteren Schutzschicht (5) aus einem anderen Material als Silicium, wobei diese untere Schutzschicht wenigstens außerhalb der Verankerungszonen monokristallin ist,
c) Bilden - auf der unteren Schutzschicht (5) - einer Silicium-Epitaxieschicht (7) auf der genannten unteren Schutzschicht, wobei diese Siliciumschicht (7) wenigstens außerhalb der Verankerungszonen monokristallin ist,
d) Bildern einer oberen Schutzschicht (9) auf der Siliciumschicht (7),
e) Ätzen der oberen Schutzschicht (9), der Siliciumschicht (7) und der unteren Schutzschicht (5) zwischen den Verankerungszonen (4) entsprechend einem Definitionsmuster der mechanischen Komponente bis zum Erreichen des monokristallinen Sililciumsubstrats (1), und Herstellen von Zugangskanälen (10) zu dem monokristallinen Siliciumsubstrat,
f) Bilden einer Schutzschicht (11) auf den Wänden des in die Silicium-Epitaxieschicht (7) hinein geätzten Musters der mechanischen Komponente,
g) Freimachen der mechanischen Komponente durch isotropes Ätzen des monokristallinen Siliciumsubstrats durch die Zugangskanäle (10) zu dem monokristallinen Siliciumsubstrat, wobei dieses isotrope Ätzen die untere (5) und obere (9) Schutzschicht und die Schutzschicht der Wände (11) nicht angreift.

2. Verfahren nach Anspruch 1, bei dem während des Schritts e) die obere Schutzschicht, die Siliciumschicht und die untere Schutzschicht ebenfalls in den Verankerungszonen entsprechend einem Muster geätzt werden, das geeignet ist, in den Epitaxieschichten eine elektrische Isolationszone herzustellen.

3. Verfahren nach Anspruch 1, bei dem vor dem Schritt e) ein Schritt zur Herstellung elektrischer Kontaktelemente (13) für die mechanischen Komponenten vorgesehen ist.

4. Verfahren nach Anspruch 3, bei dem die Herstellung der elektrischen Kontaktelemente (13) die Abscheidung einer Schicht aus elektrisch leitfähigem Material und ihre Ätzung umfasst.

5. Verfahren nach einem der Ansprüche 3 oder 4, bei dem die elektrischen Kontaktelemente (13) auf den Verankerungszonen angeordnet werden.

6. Verfahren nach einem der Ansprüche 1 bis 5, bei dem die mechanische Komponente hergestellt wird, indem zwischen den Schritten c) und d) wenigstens die beiden folgenden Schritte eingefügt werden:
- Bilden - auf der in Schritt c) erhaltenen Struktur - einer Zwischenschicht aus einem anderen Material als Silicium durch Epitaxie auf der direkt vorhergehend abgeschiedenen Siliciumschicht, wobei diese Zwischenschicht zumindest außerhalb der Verankerungszonen monokristallin ist,
- Bildern - auf der direkt vorhergehend abgeschieden Zwischenschicht und durch Epitaxie auf dieser Zwischenschicht -, einer Siliciumschicht, wobei diese Siliciumschicht zumindest außerhalb der Verankerungszonen monocristallin ist.

7. Verfahren nach einem der Ansprüche 1 bis 6, bei dem die Verankerungszonen realisiert werden, indem auf der genannten Seite (2) des Substrats (1) Gräben (3) ausgebildet werden und diese Gräben mit einem Verankerungsmaterial (4) gefüllt werden.

8. Verfahren nach Anspruch 7, bei dem das Verankerungsmaterial ein Material ist, das sukzessive die Bildung einer Epitaxieschicht (6) simultan zu der unteren Schutzschicht (5) und die Bildung einer weiteren Epitaxieschicht (8) simultan zu der Siliciumschicht (7) ermöglicht.

9. Verfahren nach einem der Ansprüche 1 bis 8, bei dem die Schutzschicht der Wände durch Abscheidung oder Epitaxie einer sich an das Relief der in dem Schritt e) geätzten Struktur anschmiegenden Schutzschicht (11) und anschließende anisotrope Ätzung dieser Schutzschicht (11) realisiert wird.

10. Verfahren nach einem der Ansprüche 1 bis 9, bei dem die Verankerungszonen aus einem elektrisch isolierenden Material gebildet werden.

11. Verfahren nach einem der Ansprüche 1 bis 10, bei dem die auf der Seite (2) des Substrats (1) ausgebildeten Verankerungszonen aus Siliciumnitrid oder Siliciumoxid sind.

12. Verfahren nach einem der Ansprüche 1 bis 11, bei dem die aus einem anderen Material als Silicium gebildete untere Schutzschicht aus SiGe ist.

13. Verfahren nach einem der Ansprüche 1 bis 12, bei dem die obere Schutzschicht (9) aus Siliciumnitrid oder Siliciumoxid ist.

14. Verfahren nach einem der Ansprüche 1 bis 13, bei dem die Schutzschicht (11) auf den Wänden aus einem unter SiGe, Siliciumoxid und Siliciumnitrid ausgewählten Material ist.

15. Verfahren nach einem der Ansprüche 1 bis 14, bei dem nach dem Schritt zur Freimachung der mechanischen Komponente ein Schritt zur Eliminierung der oberen Schutzschicht (9) und der Schutzschicht der Wände (11) vorgesehen ist.

16. Verfahren nach einem der Ansprüche 1 bis 15, bei dem nach dem Schritt zur Freimachung der mechanischen Komponente ein Schritt zur Eliminierung der unteren Schutzschicht (5) vorgesehen ist.
